# EUROPEAN PATENT APPLICATION

(11) **EP 4 794 505 A1**
(43) Date of publication of application: **19.08.2026**
(21) Application number: 26156539.4
(22) Date of filing: 05.02.2026
(51) Int. Cl.: H10N 30/00, H10N 30/853, H10N 30/20, B41J 2/14

(54) **PIEZOELECTRIC ELEMENT, LIQUID EJECTING HEAD, AND LIQUID EJECTING APPARATUS**

(30) Priority: 07.02.2025 JP 2025019283
(71) Applicant: Seiko Epson Corporation, Tokyo 160-8801 (JP)
(72) Inventor: OKADA, Shu, Suwa-shi, 392-8502 (JP); YANO, Yoshiki, Suwa-shi, 392-8502 (JP); ITO, Nobuaki, Suwa-shi, 392-8502 (JP); ASAKAWA, Tsutomu, Suwa-shi, 392-8502 (JP)
(74) Representative: Lewis Silkin LLP

(57) **Abstract**

A piezoelectric element includes: a lower electrode; a piezoelectric layer having a perovskite structure that includes K and Na in an A-site and includes Nb in a B-site; an upper electrode; and a seed layer having a perovskite structure that includes a first element in an A-site and includes a second element in a B-site and configured to control an orientation of the piezoelectric layer, in which the lower electrode, the seed layer, the piezoelectric layer, and the upper electrode are arranged in this order along a lamination direction, in the piezoelectric layer, the first element and the second element decrease with gradients from bottom to top along the lamination direction, and a degree of the gradient of the first element in the piezoelectric layer is smaller than a degree of the gradient of the second element in the piezoelectric layer.

## Description

The present application is based on, and claims priority from JP Application Serial Number 2025-019283, filed February 7, 2025, the disclosure of which is hereby incorporated by reference herein in its entirety.

### BACKGROUND

### 1. Technical Field

The present disclosure relates to a piezoelectric element, a liquid ejecting head, and a liquid ejecting apparatus.

### 2. Related Art

Image forming devices including liquid ejecting heads that eject liquids such as inks onto a medium such as printing paper were proposed in the related art. As the liquid ejecting head, a head that ejects a liquid filled in a pressure chamber from a nozzle by vibrating a diaphragm forming a wall surface of the pressure chamber with a piezoelectric element is known.

A piezoelectric element described in JP-A-2011-155272 includes a piezoelectric body formed of (KₐNa₁₋ₐ)NbO₃ including K, Na, and Nb. (KₐNa₁₋ₐ)NbO₃ has a perovskite structure represented by Formula ABO₃ and is abbreviated as KNN.

A piezoelectric element described in JP-A-2022-56335 includes: a piezoelectric layer; and a seed layer that controls an orientation of the piezoelectric layer. The seed layer is a composite oxide having a perovskite structure including at least lead (Pb), bismuth (Bi), iron (Fe), and titanium (Ti).

When the KNN piezoelectric body is used for the piezoelectric layer of JP-A-2022-56335, the elements in the seed layer may be introduced into the KNN piezoelectric body. When this introduction occurs, the A-site element of the seed layer may be substituted with the A-site element of the piezoelectric body and the B-site element of the seed layer may be substituted with the B-site element of the piezoelectric body although the amount of substitution is small. In addition, in the KNN piezoelectric body, the abundances of K and Na in the A-site vary in the layer. Specifically, in the layer, Na/K is large, that is, Na is rich. In the vicinity of an interface between the layers, Na/K is small, that is, K is rich. Accordingly, in the KNN piezoelectric body, the N-rich portion and the K-rich portion are present.

In the KNN piezoelectric body where the N-rich portion and the K-rich portion are present, it is known that, when the abundance of the element in the A-site varies due to the element moved from the seed layer, piezoelectric characteristics decrease.

### SUMMARY

A piezoelectric element according to a preferred aspect of the present disclosure includes: a lower electrode; a piezoelectric layer having a perovskite structure that includes K and Na in an A-site and includes Nb in a B-site; an upper electrode; and a seed layer having a perovskite structure that includes a first element in an A-site and includes a second element in a B-site and configured to control an orientation of the piezoelectric layer, in which the lower electrode, the seed layer, the piezoelectric layer, and the upper electrode are arranged in this order along a lamination direction, in the piezoelectric layer, the first element and the second element decrease with gradients from bottom to top along the lamination direction, and a degree of the gradient of the first element in the piezoelectric layer is smaller than a degree of the gradient of the second element in the piezoelectric layer.

A liquid ejecting apparatus according to a preferred aspect of the present disclosure includes: the liquid ejecting head; and a controller configured to control an ejecting operation from the liquid ejecting head.

### BRIEF DESCRIPTION OF THE DRAWINGS

FIG. 1 is a schematic view illustrating a configuration of a liquid ejecting apparatus according to a first embodiment.
FIG. 2 is an exploded perspective view of a liquid ejecting head illustrated in FIG. 1.
FIG. 3 is a cross-sectional view of a part of the liquid ejecting head illustrated in FIG. 2.
FIG. 4 is an enlarged cross-sectional view of a part of the liquid ejecting head illustrated in FIG. 3.
FIG. 5 is a diagram schematically illustrating the piezoelectric element of FIG. 4.
FIG. 6 is a diagram illustrating a SIMS data result of a first example.
FIG. 7 is a diagram illustrating a SIMS data result of a second example.
FIG. 8 is a diagram illustrating a SIMS data result of a third example.
FIG. 9 is a diagram illustrating a SIMS data result of Comparative Example.
FIG. 10 is a table showing predetermined values of a first element and a second element in the first example.
FIG. 11 is a table showing predetermined values of the first element and the second element in the second example.
FIG. 12 is a table showing predetermined values of the first element and the second element in the third example.
FIG. 13 is a table showing predetermined values of the first element and the second element in Comparative Example.
FIG. 14 is a diagram illustrating ratios between K and Na in precursor solutions for forming piezoelectric layers in the examples and Comparative Example.

### DESCRIPTION OF EMBODIMENTS

Hereinafter, preferred embodiments according to the present disclosure will be described with reference to the accompanying drawings. In the drawings, dimensions or scales of each section are different from the actual dimensions or scales as appropriate, and some sections are schematically illustrated for easy understanding. Further, the scope of the present disclosure is not limited to these embodiments unless it is noted in the following description that the present disclosure is particularly limited. In addition, the phrase "the element α and the element β are laminated" means that the element α and the element β need only be arranged in an up-down direction, and whether the element α and the element β are in direct contact with each other is not a problem.

The following description will be made by using an X-axis, a Y-axis, and a Z-axis that intersect each other, as appropriate. One direction along the X-axis will be referred to as an X1 direction, and a direction opposite to the X1 direction will be referred to as an X2 direction. Directions opposite to each other along the Y-axis will be referred to as a Y1 direction and a Y2 direction. Directions opposite to each other along the Z-axis will be referred to as a Z1 direction and a Z2 direction. Viewing in a direction along the Z-axis will be referred to as a "plan view". The Z-axis is typically a vertical axis. The Z1 direction is an upper side, and the Z2 direction is a lower side. Meanwhile, the Z-axis does not need to be the vertical axis. The X-axis, the Y-axis, and the Z-axis are typically orthogonal to each other, but are not limited thereto, and may intersect each other at, for example, an angle within a range of, for example, 80° or more and 100° or less.

### 1. First Embodiment

### 1-1. Overall Configuration of Liquid Ejecting Apparatus 100

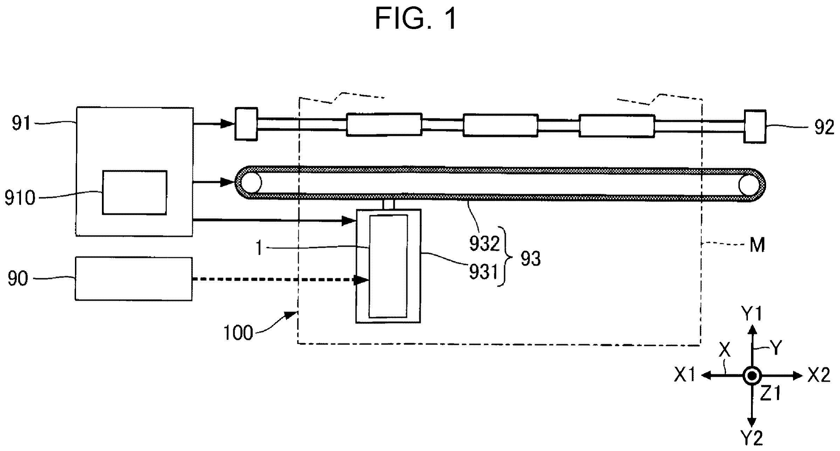

FIG. 1 is a configuration view schematically illustrating a liquid ejecting apparatus 100 according to a first embodiment. The liquid ejecting apparatus 100 is an ink jet printing apparatus that ejects ink, which is an example of liquid, to a medium M as liquid droplets. The medium M is typically printing paper. The medium M is not limited to the printing paper, and may be, for example, a printing target having any material such as a resin film or fabric.

As illustrated in FIG. 1, the liquid ejecting apparatus 100 is equipped with a liquid container 90 for storing the ink. Examples of specific aspects of the liquid container 90 include a cartridge that can be attached to and detached from the liquid ejecting apparatus 100, a bag-shaped ink pack formed of a flexible film, and an ink tank that can be refilled with the ink. A type of the ink stored in the liquid container 90 is optional.

The liquid ejecting apparatus 100 includes a controller 91, a transport mechanism 92, a moving mechanism 93, and a liquid ejecting head 1. The controller 91 includes, for example, a processing circuit such as a central processing unit (CPU) or a field programmable gate array (FPGA) and a storage circuit such as a semiconductor memory, and controls the operation of each element of the liquid ejecting apparatus 100. The controller 91 includes a voltage application circuit 910 that causes a nozzle to eject the ink by controlling driving of a piezoelectric element 5 described below. The voltage application circuit 910 applies a reference voltage VBS and a driving voltage Com to the piezoelectric element 5 described below provided in the liquid ejecting head 1.

The transport mechanism 92 transports the medium M in the Y2 direction under the control of the controller 91. The moving mechanism 93 causes the liquid ejecting head 1 to reciprocate in the X1 direction and the X2 direction under the control of the controller 91. In the example illustrated in FIG. 1, the moving mechanism 93 includes a substantially box-shaped transport body 931 called a carriage that accommodates the liquid ejecting head 1, and a transport belt 932 to which the transport body 931 is fixed. The number of liquid ejecting heads 1 mounted on the transport body 931 is not limited to one, and may be plural. The liquid container 90 may be mounted on the transport body 931 in addition to the liquid ejecting head 1.

Under the control of the controller 91, the liquid ejecting head 1 ejects the ink supplied from the liquid container 90 to the medium M from each of a plurality of nozzles toward the Z2 direction. By performing the ejection is performed in parallel with the transport of the medium M via the transport mechanism 92 and the reciprocating movement of the liquid ejecting head 1 via the moving mechanism 93, an image is formed at a surface of the medium M using the ink.

The liquid ejecting apparatus 100 includes the liquid ejecting head 1, and the controller 91 that controls the ejecting operation from the liquid ejecting head 1. Since the liquid ejecting apparatus 100 includes the liquid ejecting head 1 having the following characteristics, a decrease in piezoelectric characteristics can be suppressed. Therefore, according to the liquid ejecting apparatus 100, a decrease in ejecting performance can be suppressed.

1-2. Overall Configuration of Liquid Ejecting Head 1

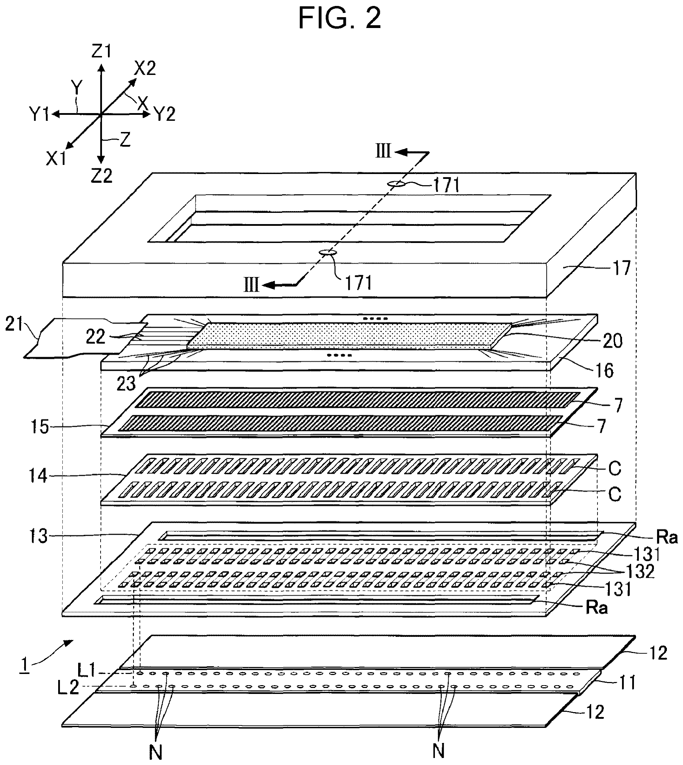

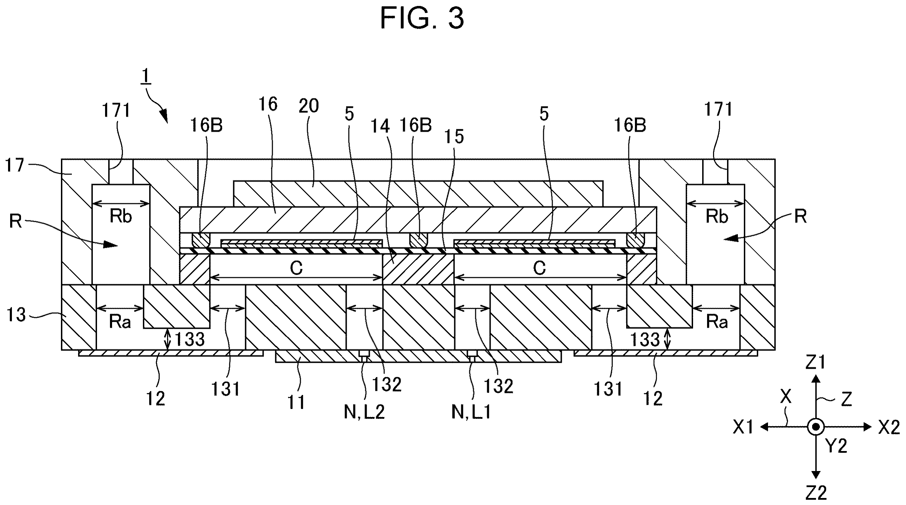

FIG. 2 is an exploded perspective view of the liquid ejecting head 1 illustrated in FIG. 1. FIG. 3 is a cross-sectional view of a part of the liquid ejecting head 1 illustrated in FIG. 2, and is a cross-sectional view taken along line III-III in FIG. 2.

As illustrated in FIG. 2, the liquid ejecting head 1 includes a plurality of nozzles N arranged in the direction along the Y-axis. In the example illustrated in FIG. 2, the plurality of nozzles N are divided into a first row L1 and a second row L2 arranged at intervals in the direction along the X-axis. Each of the first row L1 and the second row L2 is a set of the plurality of nozzles N linearly arranged in the direction along the Y-axis. An element related to each nozzle N in the first row L1 and an element related to each nozzle N in the second row L2 in the liquid ejecting head 1 are substantially symmetrical to each other in the direction along the X-axis. In the following description, the element corresponding to the first row L1 will be mainly described, and the description of the element corresponding to the second row L2 will be omitted as appropriate.

The positions of the plurality of nozzles N in the first row L1 and the positions of the plurality of nozzles N in the second row L2 in the direction along the Y-axis may be the same as or may be different from each other. In addition, the element related to each nozzle N in one of the first row L1 and the second row L2 may be omitted.

As illustrated in FIGS. 2 and 3, the liquid ejecting head 1 includes a nozzle plate 11, a vibration absorber 12, a flow path substrate 13, a pressure chamber substrate 14, a diaphragm 15, a wiring substrate 16, a housing portion 17, and a driving circuit 20. Each of the nozzle plate 11, the vibration absorber 12, the flow path substrate 13, the pressure chamber substrate 14, the diaphragm 15, the wiring substrate 16, and the housing portion 17 is a plate-shaped member that is elongated in the direction along the Y-axis. The nozzle plate 11, the flow path substrate 13, the pressure chamber substrate 14, the diaphragm 15, and the wiring substrate 16 are arranged in this order in the Z1 direction.

The nozzle plate 11 is a plate-shaped member in which the plurality of nozzles N are formed. Each of the plurality of nozzles N is a circular through-hole through which the ink passes. The nozzle N ejects the ink by the vibration of the diaphragm 15. The nozzle plate 11 is bonded to the flow path substrate 13 using, for example, an adhesive. The nozzle N is a portion that eject the liquid using a pressure applied in a pressure chamber C.

The flow path substrate 13 is formed with a flow path for supplying the ink to the plurality of nozzles N. Specifically, in the flow path substrate 13, a space Ra, a plurality of supply flow paths 131, a plurality of communication flow paths 132, and a supply liquid chamber 133 are formed. The space Ra is an elongated opening extending in the direction along the Y-axis in a plan view when viewed in the direction along the Z-axis. Each of the supply flow paths 131 and the communication flow paths 132 is a through-hole formed for each nozzle N. The supply liquid chamber 133 is an elongated space extending in the direction along the Y-axis over the plurality of nozzles N, and allows the space Ra and the plurality of supply flow paths 131 to communicate with each other. Each of the plurality of communication flow paths 132 overlaps one nozzle N corresponding to the communication flow path 132 in a plan view. The pressure chamber substrate 14 is bonded to the flow path substrate 13 using, for example, an adhesive.

In the pressure chamber substrate 14, a plurality of pressure chambers C are provided. The plurality of pressure chambers C are arranged in the direction along the Y-axis. Each pressure chamber C is formed for each nozzle N, and is an elongated space extending in the direction along the X-axis in a plan view. The pressure chamber C is a space located between the flow path substrate 13 and the diaphragm 15. The pressure chamber C communicates with the nozzle N via the communication flow path 132 and communicates with the space Ra via the supply flow path 131 and the supply liquid chamber 133. The pressure chamber C is a portion in which liquid is circulated to apply a pressure to the liquid by the piezoelectric element 5.

Each of the nozzle plate 11, the flow path substrate 13, and the pressure chamber substrate 14 is manufactured by processing a silicon single crystal substrate using, for example, dry etching or wet etching. However, other known methods may be used as appropriate for manufacturing the nozzle plate 11, the flow path substrate 13, and the pressure chamber substrate 14.

The diaphragm 15 is disposed on a surface of the pressure chamber substrate 14 facing the Z1 direction. The diaphragm 15 is a plate-shaped member that can elastically vibrate.

A plurality of piezoelectric elements 5 corresponding to the nozzles N are disposed on a surface of the diaphragm 15 facing the Z1 direction. Each piezoelectric element 5 has an elongated shape extending in the direction along the X-axis in a plan view. The plurality of piezoelectric elements 5 correspond to the plurality of pressure chambers C, and are arranged in the direction along the Y-axis. The piezoelectric element 5 is deformed due to the application of a voltage. When the diaphragm 15 vibrates in conjunction with the deformation, the pressure in the pressure chamber C fluctuates, so that the ink is ejected from the nozzle N.

The housing portion 17 is a case for storing the ink supplied to the plurality of pressure chambers C. As illustrated in FIG. 3, a space Rb is formed in the housing portion 17. The space Rb of the housing portion 17 and the space Ra of the flow path substrate 13 communicate with each other. A space formed by the space Ra and the space Rb functions as a liquid storage chamber R that is a reservoir that stores the ink supplied to the plurality of pressure chambers C. The ink is supplied to the liquid storage chamber R through an inlet 171 formed in the housing portion 17. The ink in the liquid storage chamber R is supplied to the pressure chamber C through the supply liquid chamber 133 and each supply flow path 131.

The vibration absorber 12 is a flexible film that forms a wall surface of the liquid storage chamber R. The vibration absorber 12 is a compliance substrate that absorbs the fluctuation in the pressure of the ink in the liquid storage chamber R.

The wiring substrate 16 is a plate-shaped member in which wirings for electrically coupling the driving circuit 20 and the plurality of piezoelectric elements 5 are formed. A surface of the wiring substrate 16 facing the Z2 direction is bonded to the diaphragm 15 via a plurality of conductive bumps 16B. On the other hand, the driving circuit 20 is mounted on a surface of the wiring substrate 16 facing the Z1 direction. The driving circuit 20 is an integrated circuit (IC) chip that outputs the driving voltage Com and the reference voltage VBS for driving each piezoelectric element 5.

As illustrated in FIG. 2, an end portion of an external wiring 21 is bonded to a surface of the wiring substrate 16 facing the Z1 direction. The external wiring 21 is formed of, for example, coupling components such as flexible printed circuits (FPC) or flexible flat cables (FFC). The wiring substrate 16 is formed with a plurality of wirings 22 that electrically couple the external wiring 21 and the driving circuit 20, and a plurality of wirings 23 to which the driving voltage Com and the reference voltage VBS output from the driving circuit 20 are supplied.

The wiring substrate 16 is not limited to a rigid substrate, and may be, for example, flexible printed circuits (FPC) or a flexible flat cable (FFC). In this case, the wiring substrate 16 may also serve as the external wiring 21.

In this liquid ejecting head 1, when the piezoelectric elements 5 are bent and deformed due to the application of a voltage, the diaphragm 15 is bent and deformed, that is, vibrates, in a direction in which the volume of the pressure chambers C decreases. As a result, the pressure in the pressure chambers C changes, and the ink in the pressure chambers C is ejected from the nozzle N. The piezoelectric element 5 returns to the original position after the ink is ejected.

In addition, the liquid ejecting head 1 includes all of each of the elements illustrated in FIG. 3. However, the components of the liquid ejecting head 1 do not need to include all of the elements and may further include additional elements.

### 1-3. Diaphragm 15 and Piezoelectric Element 5

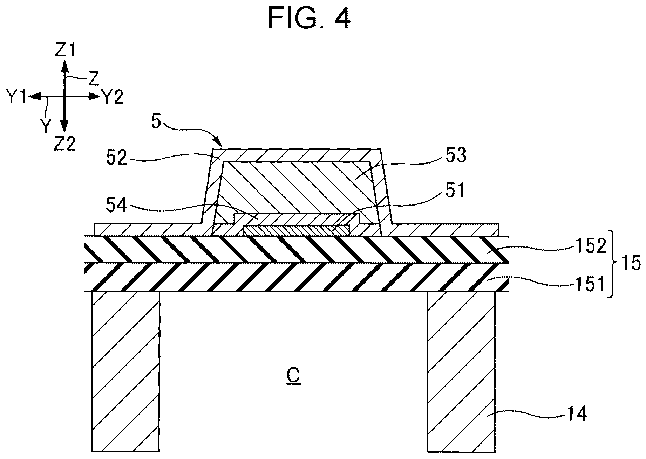

FIG. 4 is a cross-sectional view illustrating a part of the liquid ejecting head 1 of FIG. 3. In the example illustrated in FIG. 4, the diaphragm 15 is formed of a laminate including a first vibration layer 151 and a second vibration layer 152. The first vibration layer 151 is in contact with the pressure chamber substrate 14. The second vibration layer 152 is disposed above the first vibration layer 151. The first vibration layer 151 is formed of an elastic material such as silicon oxide (SiOₓ). The second vibration layer 152 is formed of an insulating material such as zirconium oxide (ZrOₓ). The first vibration layer 151 is formed, for example, by thermally oxidizing a part of the pressure chamber substrate 14. The second vibration layer 152 is formed, for example, by a known film forming technique such as sputtering. The diaphragm 15 may include one layer or may include three or more layers.

The piezoelectric element 5 is provided on the diaphragm 15. The piezoelectric element 5 mainly includes a lower electrode 51, a piezoelectric layer 53, an upper electrode 52, and a seed layer 54. The lower electrode 51, the seed layer 54, the piezoelectric layer 53, and the upper electrode 52 are laminated in the direction along the Z-axis that is the lamination direction.

The lower electrode 51 is provided above the diaphragm 15. The lower electrode 51 is an individual electrode provided for each piezoelectric element 5. The driving voltage Com that fluctuates is applied to the lower electrode 51. The lower electrode 51 is elongated along the X-axis. A plurality of lower electrodes 51 are arranged along the Y-axis at intervals. The lower electrode 51 includes, for example, a conductive material such as platinum (Pt). The thickness of the lower electrode 51 along the Z-axis is not particularly limited, and is, for example, 50 nm or more and 120 nm or less.

The seed layer 54 is provided for controlling an orientation of the piezoelectric layer 53. The thickness of the seed layer 54 along the Z-axis is less than the thickness of the piezoelectric layer 53 along the Z-axis. The thickness of the seed layer 54 along the Z-axis is not particularly limited, and is, for example, 5 nm or more and 50 nm or less.

The piezoelectric layer 53 is, for example, a strip-shaped dielectric film that is continuous along the Y-axis across the plurality of piezoelectric elements 5. The piezoelectric layer 53 has, for example, a strip shape extending along the Y-axis and is separated for each piezoelectric element 5 by forming a plurality of notches. The thickness of the piezoelectric layer 53 along the Z-axis is not particularly limited, and is, for example, 300 nm or more and 1500 nm or less.

The upper electrode 52 is provided above the piezoelectric layer 53. The upper electrode 52 is a strip-shaped common electrode that extends along the Y-axis so as to be continuous across the plurality of the piezoelectric elements 5. The predetermined reference voltage VBS is applied to the upper electrode 52. The upper electrode 52 includes, for example, a conductive material such as iridium (Ir). The thickness of the upper electrode 52 along the Z-axis is not particularly limited, and is, for example, 50 nm or more and 120 nm or less.

In the piezoelectric element 5, a voltage corresponding to a difference between the reference voltage VBS applied to the upper electrode 52 and the driving voltage Com corresponding to the ejection amount supplied to the lower electrode 51 is applied to the piezoelectric layer 53. By applying a voltage between the lower electrode 51 and the upper electrode 52, the piezoelectric layer 53 deforms such that the piezoelectric element 5 is bent and deformed, that is, vibrates.

In the present embodiment, the lower electrode 51 is an individual electrode and the upper electrode 52 is a common electrode. However, the lower electrode 51 may be a common electrode, and the upper electrode 52 may be an individual electrode.

### 1-4. Seed Layer 54 and Piezoelectric Layer 53

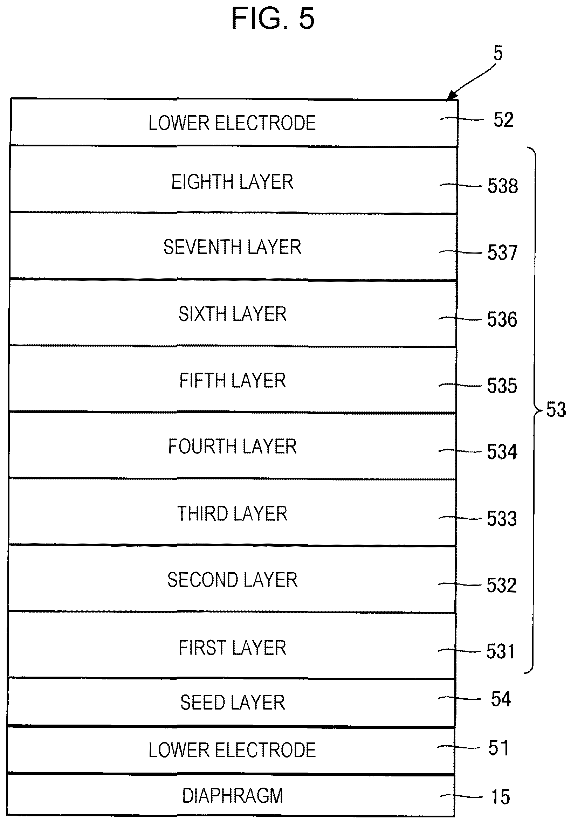

FIG. 5 is a diagram schematically illustrating the piezoelectric element 5 of FIG. 4. As illustrated in FIG. 5, in the present embodiment, the piezoelectric layer 53 is formed of, for example, a laminate including a plurality of layers. Specifically, in the piezoelectric layer 53, N layers including a first layer to an N-th layer are laminated from bottom to top. In the present embodiment, N is 8. Accordingly, in the example illustrated in the drawing, the piezoelectric layer 53 is formed of a laminate of eight layers including a first layer 531, a second layer 532, a third layer 533, a fourth layer 534, a fifth layer, 535, a sixth layer 536, a seventh layer 537, and an eighth layer 538.

In addition, the piezoelectric layer 53 has a perovskite structure that includes K and Na in an A-site and includes Nb in a B-site. Specifically, the piezoelectric layer 53 includes potassium sodium niobate ((KₐNa₁₋ₐ)NbO₃). (KₐNa₁₋ₐ)NbO₃ has a perovskite structure represented by Formula ABO₃ and is abbreviated as KNN. Each of the plurality of layers in the piezoelectric layer 53 includes KNN.

The thicknesses of the layers in the piezoelectric layer 53 may be different from or the same as each other. In addition, in the present embodiment, each layer in the piezoelectric layer 53 is formed by applying, for example, a precursor solution that is formed of a sol including a metal complex including K, Na, and Nb to the seed layer 54 to form a piezoelectric precursor film, and drying and degreasing the piezoelectric precursor film at a predetermined temperature. The piezoelectric layer 53 may be formed using another methods. For example, the piezoelectric layer 53 may be formed by applying, drying, and degreasing a MOD solution, or may be formed using a sputtering method or the like.

In addition, the seed layer 54 has the perovskite structure. The seed layer 54 includes, for example, lead titanate PbₐTi_{b}O_{z}, lanthanum nickel oxide LaₐNi_{b}O_{z}, PbₓBi₍ₐ₋ₓ₎Fe_{y}Ti_{(b-y)}O_{z}, BiₐFe_{y}Ti_{(b-y)}O_{z}, or PbₐFe_{y}Ti_{(b-y)}O_{z}. In the above-described chemical formulae, it is necessary to satisfy 0 < x <a and 0 < y < b. In addition, in the chemical formulae, it is preferable to satisfy 0.8 ≤ a ≤ 1.2 and 0.8 ≤ b ≤ 1.2. In addition, in the chemical formulae, it is more preferable to satisfy a = 1, b = 1, and z = 3. In PbₐTi_{b}O_{z}, the A-site element is Pb, and the B-site element is Ti. In LaₐNi_{b}O_{z},, the A-site element is La, and the B-site element is Ni. In PbₓBi₍ₐ₋ₓ₎Fe_{y}Ti_{(b-y)}O_{z}, the A-site elements are Bi and Pb, and the B-site elements are Fe and Ti. In BiₐFe_{y}Ti_{(b-y)}, the A-site element is Bi, and the B-site elements are Fe and Ti. In PbₐFe_{y}Ti_{(b-y)}O_{z}, the A-site element is Pb, and the B-site elements are Fe and Ti. Hereinafter, PbₓBi₍ₐ₋ₓ₎Fe_{y}Ti_{(b-y)}O_{z} will be simply referred to as "PbBiFeTiO". PbₓFe_{y}Ti_{(1-y)}O_{z} will be simply referred to as "PbFeTiO". In addition, the seed layer 54 may include a composite oxide having a perovskite structure including Bi, Fe, and Ti. In particular, it is preferable that the seed layer 54 includes PbBiFeTiO. PbBiFeTiO has excellent orientation controllability, and thus is particularly preferable.

### 1-5. Composition of Piezoelectric Element 5

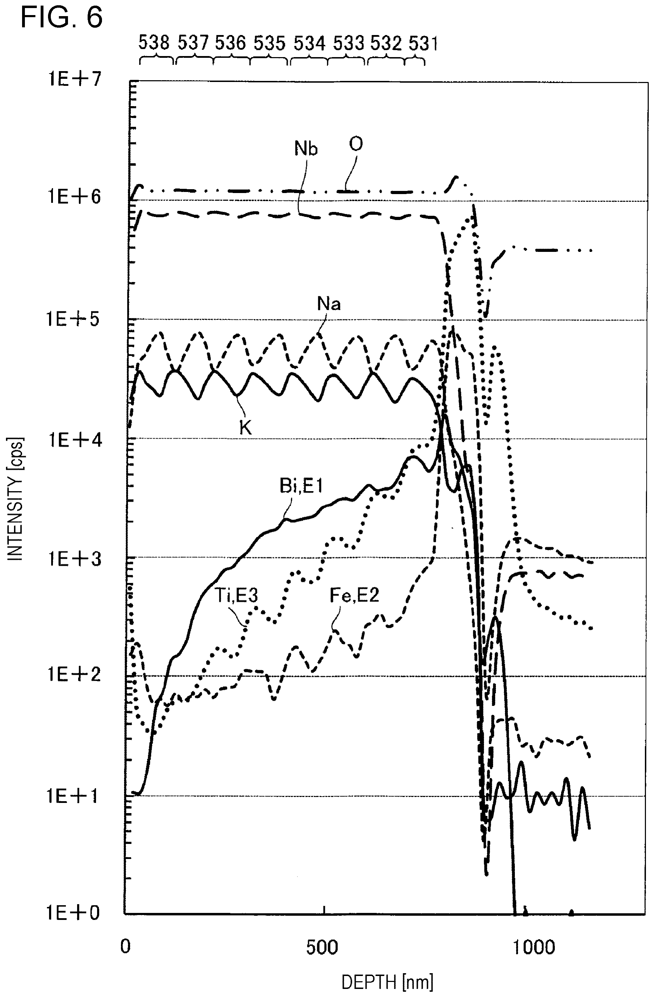

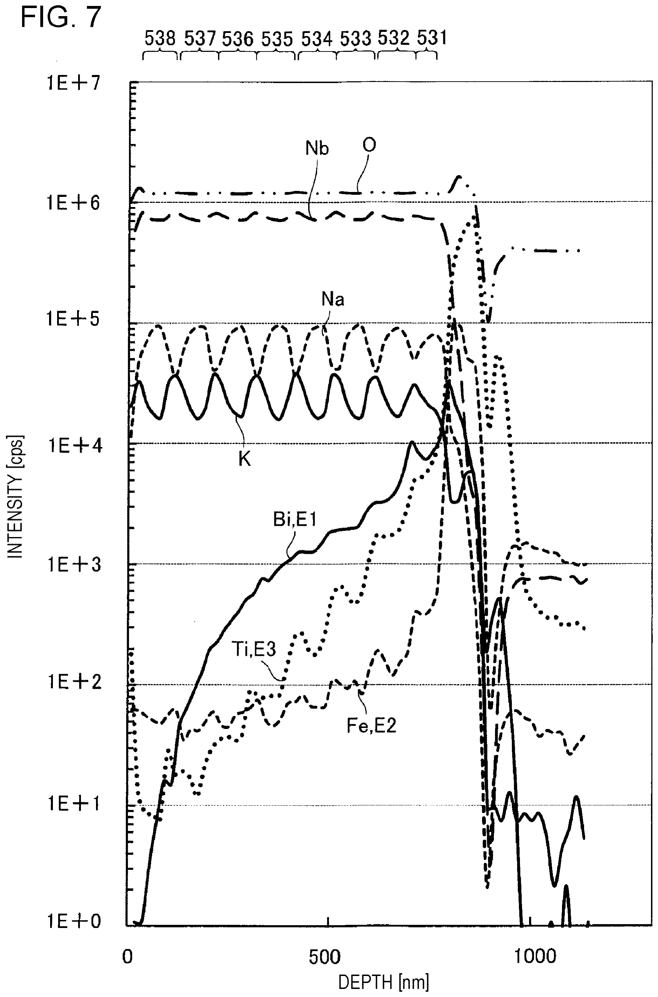

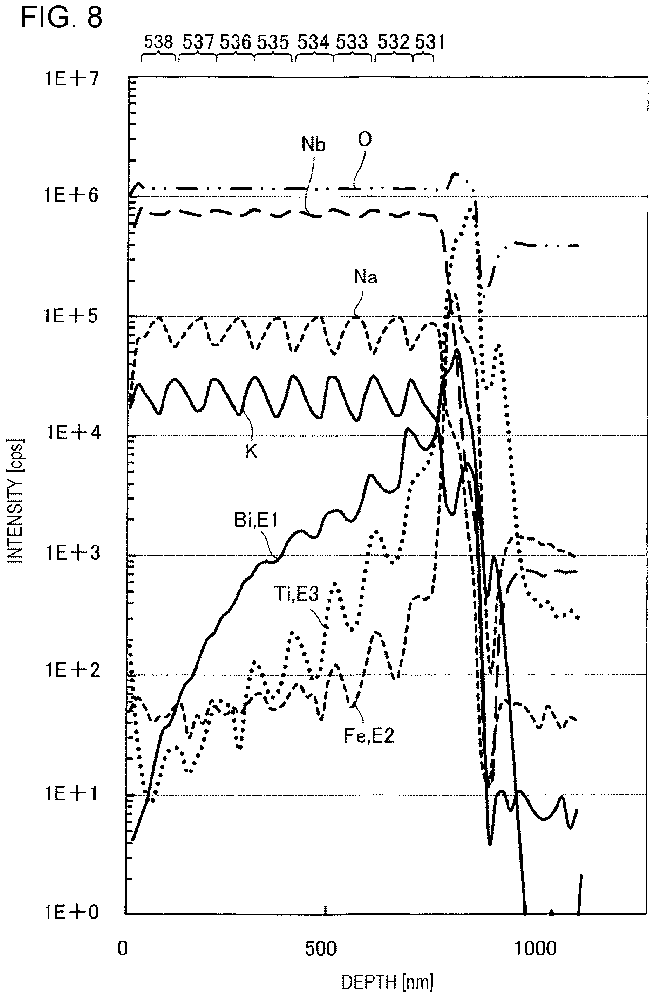

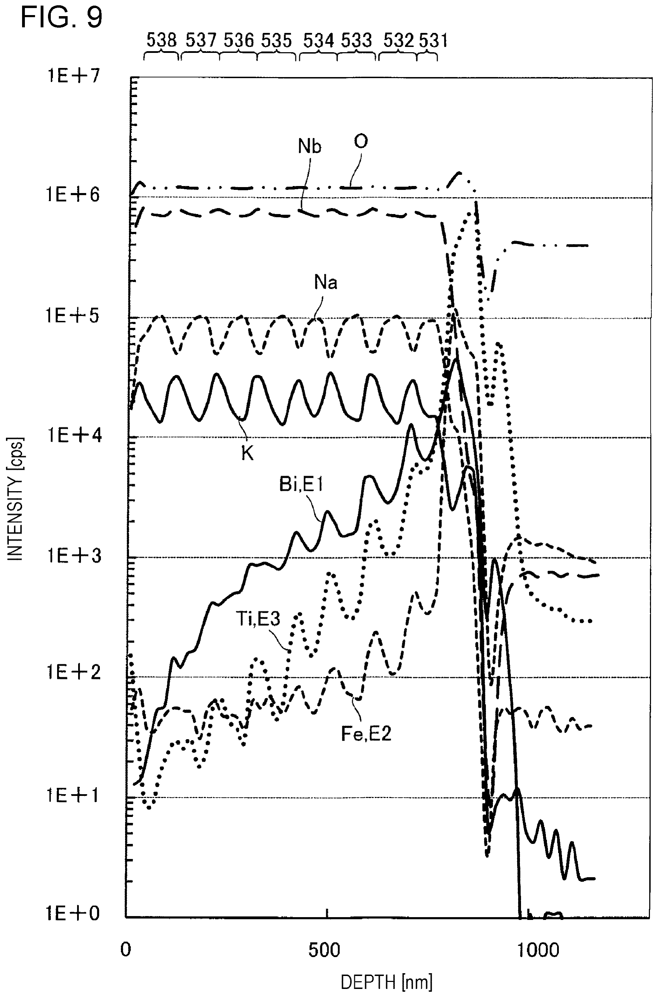

FIG. 6 is a diagram illustrating a SIMS data result of a first example. FIG. 7 is a diagram illustrating a SIMS data result of a second example. FIG. 8 is a diagram illustrating a SIMS data result of a third example. FIG. 9 is a diagram illustrating a SIMS data result of Comparative Example.

SIMS is an abbreviation for secondary ion mass spectrometry. In the SIMS measurement of each of the examples and Comparative Example, a sample surface was irradiated with Cs+ having an acceleration energy of 15 KeV and a current of 10 nA as a primary ion beam to detect negative secondary ions. In the measurement, the electron beam irradiation was performed by setting a high mass resolution mode to remove the effect of interfering ions, and forming an Au coating film on the sample surface to prevent charge-up occurring during measurement of an insulating material.

In each drawing, the horizontal axis represents the depth. The vertical axis represents the secondary ion intensity. In the SIMS data result of each drawing, cluster ions associated with oxygen are detected to enhance the generation efficiency of the secondary ions in the measurement of each element. In addition, the SIMS data result of each drawing is the result of performing the SIMS measurement while digging the sample from the upper electrode 52 to the lower electrode 51. Accordingly, the depth [nm] of the eighth layer 538 in the piezoelectric layer 53 is less than the depth [nm] of the first layer 531. Among the plurality of layers in the piezoelectric layer 53, the eighth layer 538 is closest to a depth of 0 [nm]. In addition, "1E+" of the vertical axis is the exponential notation representing the power of 10. For example, "1E+7" represents "1×10⁷". Accordingly, in the piezoelectric layer 53, the eighth layer 538 is positioned on the uppermost layer, and the first layer 531 is located on the lowermost layer.

In each of the first example, the second example, the third example, and Comparative Example, the piezoelectric layer 53 includes KNN, and the seed layer 54 includes PbBiFeTiO. As described above, in KNN, the A-site elements are K and Na, and the B-site element is Nb. As described above, in PbBiFeTiO, the A-site elements are Bi and Pb, and the B-site elements are Fe and Ti.

As illustrated in FIGS. 6 to 9, in each of the examples and Comparative Example, in the piezoelectric layer 53, the abundance of oxygen (O) and the abundance of niobium (Nb) are substantially constant. On the other hand, in the piezoelectric layer 53, each of the abundances of potassium (K) and sodium (Na) in the A-site vary. In the piezoelectric layer 53, Na/K is large in each of the layers, and Na/K is small between the layers. This way, in the piezoelectric layer 53, an Na-rich portion and a K-rich portion are present.

In addition, in each of the examples and Comparative Example, in the piezoelectric layer 53, a first element E1, a second element E2, and a third element E3 are present. In each of the examples and Comparative Example illustrated in FIGS. 6 to 9, the first element E1 is Bi, the second element E2 is Fe, and the third element E3 is Ti. Each of the first element E1, the second element E2, and the third element E3 is an element other than the elements forming KNN, that is, is an element other than K, Na, Nb, and O. Each of the first element E1, the second element E2, and the third element E3 is an element in the seed layer 54 that is an element moved from the seed layer 54 to the piezoelectric layer 53. In addition, the first element E1 is the A-site element of the seed layer 54, and each of the second element E2 and the third element E3 is the B-site element of the seed layer 54. For example, the first element E1 may be Pb, and the second element E2 may be Ti. Here, in the seed layer 54 used in each of the examples and Comparative Example, Pb is much smaller than Bi. Therefore, as illustrated in FIGS. 6 to 9, Pb is not substantially present in the piezoelectric layer 53.

In each of the examples and Comparative Example, in the piezoelectric layer 53, each of the first element E1, the second element E2, and the third element E3 decreases with gradients from bottom to top along the lamination direction, that is, from the first layer 531 to the eighth layer 538. The reason for this is presumed to be that the first element E1, the second element E2, and the third element E3 are moved into the piezoelectric layer 53 from the seed layer 54 that is a layer below the piezoelectric layer 53. Therefore, each of the abundances of the first element E1, the second element E2, and the third element E3 is larger in the vicinity of the first layer 531 than that in the vicinity of the eighth layer 538.

Here, it was found that, in a specific case, a decrease in the piezoelectric characteristics of the piezoelectric layer 53 increases. As a result of the investigation, it was found that the presumed cause for the decrease in the piezoelectric characteristics is that, when the first element E1 that is the element other than the elements forming the KNN is introduced into the piezoelectric layer 53 of KNN, the abundance ratio between NaNbO and KNbO forming KNN varies.

Specifically, when the first element E1 (in the example, Bi) that is the element corresponding to the A-site of the seed layer 54 moves into the piezoelectric layer 53, the first element E1 may be substituted with Na that is the A-site element of NaNbO and K that is the A-site element of KNbO.

First, as described above, in the piezoelectric layer 53, K and Na do not have uniform distributions, and a compositional gradient is generated such that Na is rich in the layer and K is rich between the layers. For example, even when the same amounts of K and Na are prepared in the raw material stage of the piezoelectric layer 53, Na/K in the layer is different from that between the layers in the process of forming the piezoelectric layer 53. Here, a system will be described as an example, in which regarding the abundances of Na and K per unit film thickness, Na is 60 mol/µm and K is 40 mol/µm in the Na-rich portion in the layer, and Na is 40 mol/µm and K is 60 mol/µm in the K-rich portion between the layers. At this time, when the first element E1 of the seed layer 54 is introduced into the piezoelectric layer 53 by 35 mol/µm per unit film thickness, the first element E1 in the piezoelectric layer 53 varies by about ±15 mol/µm, is present by 20 (= 35 - 15) mol/µm in the Na-rich portion in the layer, and is present by 50 (= 35 + 15) mol/µm in the K-rich portion between the layers.

At this time, the first element E1 introduced into the piezoelectric layer 53 is substituted with Na as the A-site element of NaNbO or K as the A-site element of KNbO forming the solid solution of KNN of the piezoelectric layer 53. Since Na and K have ionic valences close to each other and ionic radii close to each other, the substitution occurs for Na and K substantially at the same probability. As a result, as described above, in the Na-rich portion, the abundance of the first element is 20 mol/µm, and Na:K = 60:40. Therefore, the first element E1 is substituted with Na of NaNbO by 20 mol/µm × 0.6 = 12 mol/µm and is substituted with K of KNbO by 20 mol/µm × 0.4 = 8 mol/µm. Accordingly, finally, in the Na-rich portion, NaNbO is 48 (= 60 - 12) mol/µm, and KNbO is 32 (= 40 - 8) mol/µm. Likewise, in the K-rich portion, the abundance of the first element is 50 mol/µm, and Na:K = 40:60. Therefore, the first element E1 is substituted with Na of NaNbO by 50 mol/µm × 0.4 = 20 mol/µm and is substituted with K of KNbO by 50 mol/µm × 0.6 = 30 mol/µm. Accordingly, finally, in the K-rich portion, NaNbO is 20 (= 40 - 20) mol/µm, and KNbO is 30 (= 60 - 30) mol/µm. As a result, in the entire piezoelectric layer 53, NaNbO is 68 (= 48 + 20) mol/µm and KNbO is 62 (= 32 + 30) mol/µm, which are different values.

This way, the abundance ratio between NaNbO and KNbO varies due to a variation in the first element E1 introduced into the piezoelectric layer 53. In the piezoelectric layer 53, the abundance ratio between NaNbO and KNbO varies between the N-rich portion and K-rich portion. In the piezoelectric layer 53, when the control of the ratio between NaNbO and KNbO is difficult, the piezoelectric characteristics further decrease. That is, in the piezoelectric layer 53, when the abundance ratio between NaNbO and KNbO varies, the decrease in piezoelectric characteristics is significant.

On the other hand, a case is assumed where the above-described variation of about ±15 mol/µm in the first element E1 between the Na-rich portion and the K-rich portion does not occur in the piezoelectric layer 53 and the first element E1 is, for example, 35 mol/µm in both the Na-rich portion and the K-rich portion. In the Na-rich portion, the abundance of the first element is 35 mol/µm, and Na:K = 60:40. Therefore, the first element E1 is substituted with Na of NaNbO by 35 mol/µm × 0.6 = 21 mol/µm and is substituted with K of KNbO by 35 mol/µm × 0.4 = 14 mol/µm. Accordingly, finally, in the Na-rich portion, NaNbO is 39 (= 60 - 21) mol/µm, and KNbO is 26 (= 40 - 14) mol/µm. Likewise, in the K-rich portion, the abundance of the first element is 35 mol/µm, and Na:K = 40:60. Therefore, the first element E1 is substituted with Na of NaNbO by 35 mol/µm × 0.4 = 14 mol/µm and is substituted with K of KNbO by 35 mol/µm × 0.6 = 21 mol/µm. Accordingly, finally, in the K-rich portion, NaNbO is 26 (= 40 - 14) mol/µm, and KNbO is 39 (= 60 - 21) mol/µm. As a result, in the entire piezoelectric layer 53, NaNbO is 65 (= 39 + 26) mol/µm and KNbO is 65 (= 26 + 39) mol/µm, which are the same value. This way, the ratio between NaNbO and KNbO varies individually between the Na-rich portion and the K-rich portion but is 65 mol/µm and 1:1 as a whole. Therefore, the ratio between NaNbO and KNbO does not deviate from the ideal value, and thus the piezoelectric characteristics are not reduced.

From the above, in the piezoelectric layer 53, K and Na as the A-site elements vary in the layer, and thus it is not preferable that the first element E1 that can be substituted with the A-site element varies.

On the other hand, the second element (in the example, Fe, Ti) that is the element corresponding to the B-site of the seed layer 54 may be moved into the piezoelectric layer 53 and substituted with Nb that is the B-site element of each of NaNbO and KNbO. However, regarding Nb that is the B-site element of the piezoelectric layer 53, a variation in the layer is small, and only Nb is present in the B-site. Accordingly, even when the second element E2 varies, unlike the first element, the ratio between NaNbO and KNbO does not deviate from the ideal value, and the problem of the decrease in piezoelectric characteristics does not occur. Rather, the other adverse effects may occur due to an unnecessary control for suppressing a variation in the second element E2. Therefore, a variation in the second element E2 that can be substituted with Nb that is the B-site element of the piezoelectric layer 53 is intentionally allowed.

From the above, it was found that, by reducing a variation in the first element E1 as the A-site element as compared to a variation in the second element E2 as the B-site element in the piezoelectric layer 53, a variation in the abundance ratio between NaNbO and KNbO can be suppressed while suppressing the occurrence risk of other adverse effects.

Here, as described above, each of the first element E1 and the second element E2 decreases with a gradient from the first layer 531 to the eighth layer 538. Therefore, in the piezoelectric layer 53, by reducing the degree of the gradient of the first element E1 as compared to the degree of the gradient of the second element E2, a variation in the first element E1 can be reduced as compared to a variation in the second element E2. Accordingly, a variation in the abundance ratio between NaNbO and KNbO can be suppressed while suppressing the occurrence risk of other adverse effects. Accordingly, a decrease in piezoelectric characteristics can be suppressed.

The above-described degree of the gradient is the degree that decreases from bottom to top along the lamination direction. The degree of the gradient being small represents that the slope of the decrease is small. In addition, the degree of the gradient may be understood as an unevenness shape or a variation shape of the secondary ion intensity. In this case, the degree of the gradient being small represents that the unevenness shape is small or a variation in the secondary ion intensity is small.

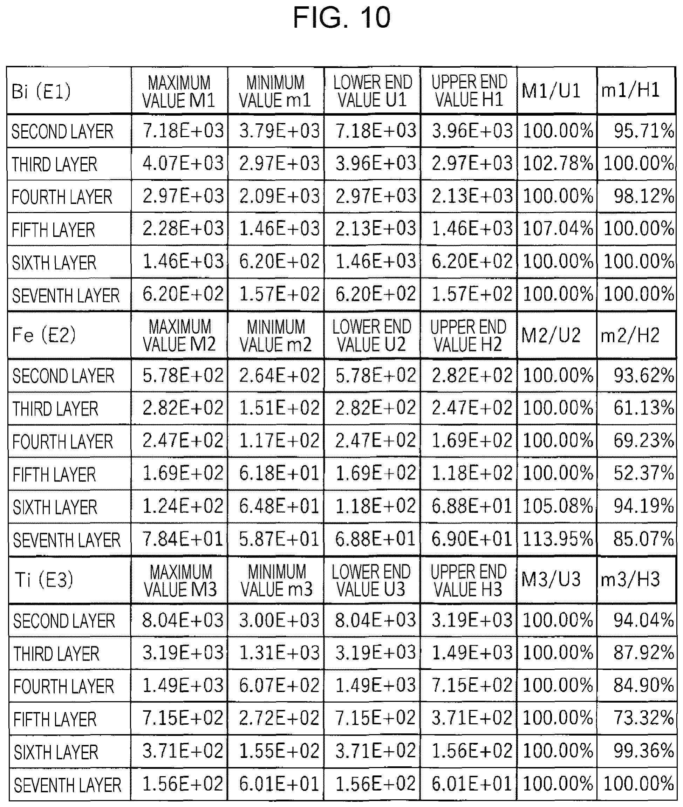

In each of the examples illustrated in FIGS. 6 to 9, the degree of the gradient of the first element E1 in the piezoelectric layer 53 is smaller than the degree of the gradient of the second element E2 in the piezoelectric layer 53. On the other hand, in Comparative Example illustrated in FIG. 10, it is difficult to say that the degree of the gradient of the first element E1 in the piezoelectric layer 53 is smaller than the degree of the gradient of the second element E2 in the piezoelectric layer 53.

In each of the examples, a decrease in piezoelectric characteristics is suppressed as compared to Comparative Example. For example, as an evaluation of the piezoelectric characteristics, when the displacement of the piezoelectric element 5 during application of a predetermined voltage is within ±10% from a sample as a non-defective product, it is determined that a decrease in piezoelectric characteristics is small, and when the displacement exceeds ±10%, it is determined that a decrease in piezoelectric characteristics is large.

In addition, by reducing the degree of the gradient of the first element E1 as compared to the degree of the gradient of the third element E3 as in the second element E2, a variation in the first element E1 can be reduced as compared to a variation in the third element E3. Accordingly, a variation in the abundance ratio between NaNbO and KNbO can be suppressed while suppressing the occurrence risk of other adverse effects. Accordingly, a decrease in piezoelectric characteristics can be suppressed.

In each of the examples illustrated in FIGS. 6 to 9, the degree of the gradient of the first element E1 in the piezoelectric layer 53 is smaller than the degree of the gradient of the third element E3 in the piezoelectric layer 53. On the other hand, in Comparative Example illustrated in FIG. 10, it is difficult to say that the degree of the gradient of the first element E1 in the piezoelectric layer 53 is smaller than the degree of the gradient of the third element E3 in the piezoelectric layer 53. In each of the examples, a decrease in piezoelectric characteristics is suppressed as compared to Comparative Example.

In addition, in FIGS. 6 to 9, the degree of the gradient is shown in the SIMS data. However, as long as the qualitative or quantitative abundance of each element can be seen, the degree of gradient in the other data may be used.

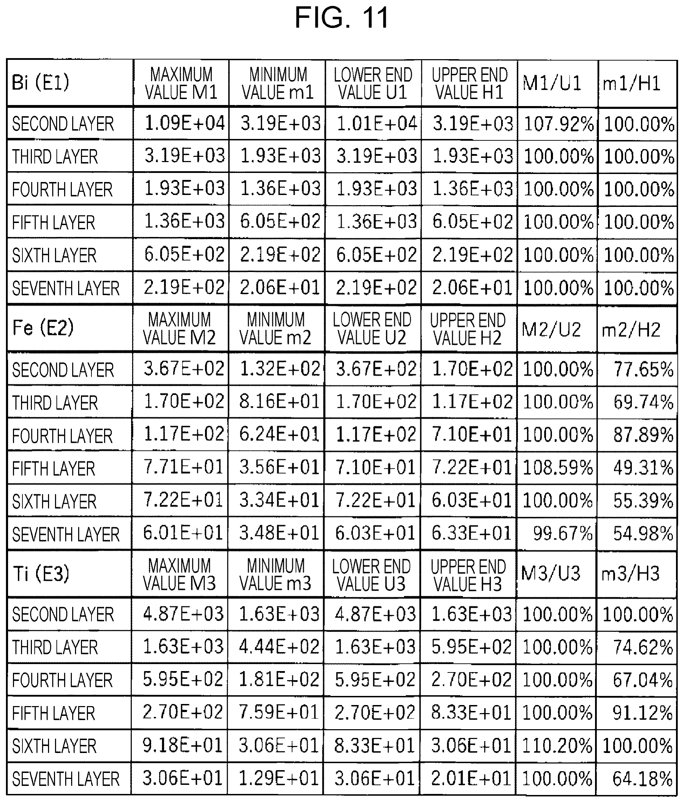

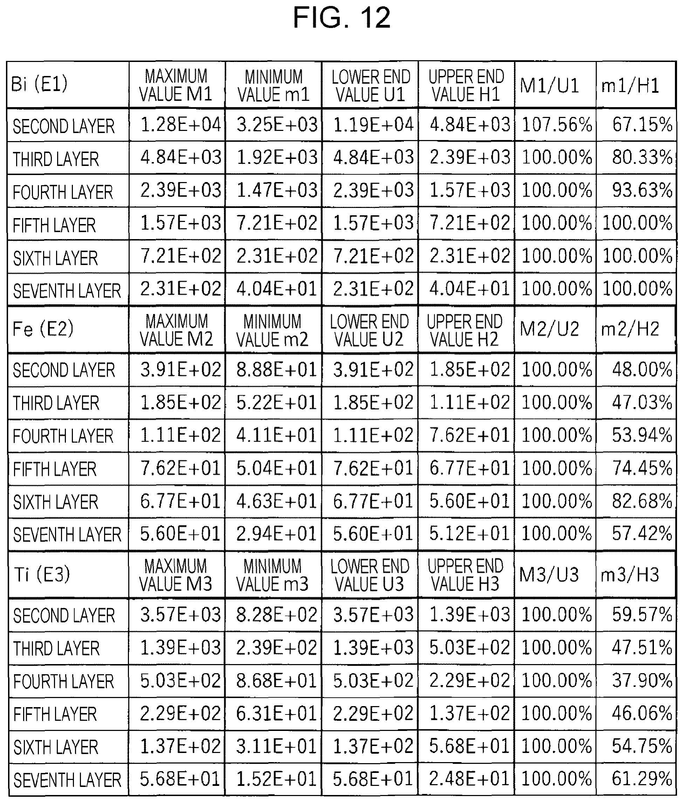

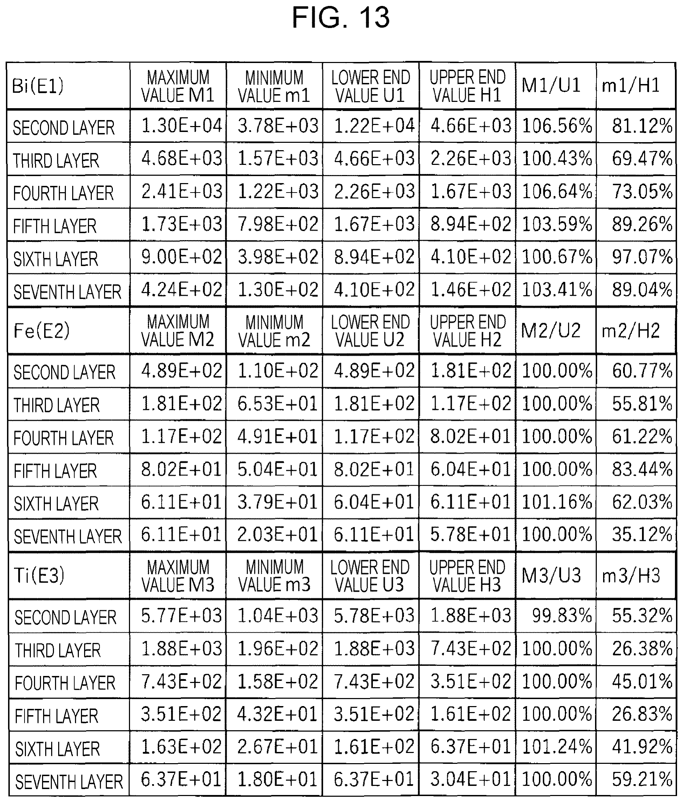

FIG. 10 is a table showing predetermined values of the first element E1 and the second element E2 in the first example. FIG. 10 shows the predetermined values based on the SIMS data result of the first example of FIG. 6. FIG. 11 is a table showing predetermined values of the first element E1 and the second element E2 in the second example. FIG. 11 shows the predetermined values based on the SIMS data result of the second example of FIG. 7. FIG. 12 is a table showing predetermined values of the first element E1 and the second element E2 in the third example. FIG. 12 shows the predetermined values based on the SIMS data result of the third example of FIG. 8. FIG. 13 is a table showing predetermined values of the first element E1 and the second element E2 in Comparative Example. FIG. 13 shows the predetermined values based on the SIMS data result of Comparative Example of FIG. 9.

In FIGS. 10 to 13, regarding the first element E1, a first minimum value m1, a first upper end value H1, a first maximum value M1, and a first lower end value U1 are shown. In addition, regarding the second element E2, a second minimum value m2, a second upper end value H2, a second maximum value M2, and a second lower end value U2 are shown. Regarding the third element E3, a third minimum value m3, a third upper end value H3, a third maximum value M3, and a third lower end value U3 are shown.

The first minimum value m1 is the minimum value of the intensity of the first element E1 in each of the layers when the piezoelectric layer 53 is measured by SIMS along the lamination direction. The first upper end value H1 is the intensity of the first element E1 in the uppermost region in each of the layers when the piezoelectric layer 53 is measured by SIMS along the lamination direction. The first maximum value M1 is the maximum value of the intensity of the first element E1 in each of the layers when the piezoelectric layer 53 is measured by SIMS along the lamination direction. The first lower end value U1 is the intensity of the first element in the lowermost region in each of the layers when the piezoelectric layer 53 is measured by SIMS along the lamination direction.

The second minimum value m2 is the minimum value of the intensity of the second element E2 in each of the layers when the piezoelectric layer 53 is measured by SIMS along the lamination direction. The second upper end value H2 is the intensity of the second element E2 in the uppermost region in each of the layers when the piezoelectric layer 53 is measured by SIMS along the lamination direction. The second maximum value M2 is the maximum value of the intensity of the second element E2 in each of the layers when the piezoelectric layer 53 is measured by SIMS along the lamination direction. The second lower end value U2 is the intensity of the second element E2 in the lowermost region in each of the layers when the piezoelectric layer 53 is measured by SIMS along the lamination direction.

The third minimum value m3 is the minimum value of the intensity of the third element E3 in each of the layers when the piezoelectric layer 53 is measured by SIMS along the lamination direction. The third upper end value H3 is the intensity of the third element E3 in the uppermost region in each of the layers when the piezoelectric layer 53 is measured by SIMS along the lamination direction. The third maximum value M3 is the maximum value of the intensity of the third element E3 in each of the layers when the piezoelectric layer 53 is measured by SIMS along the lamination direction. The third lower end value U3 is the intensity of the third element E3 in the lowermost region in each of the layers when the piezoelectric layer 53 is measured by SIMS along the lamination direction.

In addition, a ratio M1/U1 is a ratio of the first maximum value M1 to the first lower end value U1. A ratio M2/U2 is a ratio of the second maximum value M2 to the second lower end value U2. A ratio M3/U3 is a ratio of the third maximum value M3 to the third lower end value U3. In addition, a ratio m1/H1 is a ratio of the first minimum value m1 to the first upper end value H1. A ratio m2/H2 is a ratio of the second minimum value m2 to the second upper end value H2. A ratio m3/H3 is a ratio of the third minimum value m3 to the third upper end value H3.

It is preferable that the degree of the gradient of the first element E1 is obtained based on the first minimum value m1 and the first upper end value H1. It is preferable that the degree of the gradient of the second element E2 is obtained based on the second minimum value m2 and the second upper end value H2. The degree of the gradient of the first element E1 is clarified by using the first minimum value m1 and the first upper end value H1, and the degree of the gradient of the second element E2 is clarified by using the second minimum value m2 and the second upper end value H2.

By setting the degree of the gradient of the first element E1 obtained based on the first minimum value m1 and the first upper end value H1 to be less than the degree of the gradient of the second element E2 obtained based on the second minimum value m2 and the second upper end value H2, a variation in the first element E1 can be reduced as compared to a variation in the second element E2 in the piezoelectric layer 53. Therefore, a decrease in piezoelectric characteristics can be suppressed.

In addition, the same applies to the third element E3 as in the second element E2. It is preferable that the degree of the gradient of the third element E3 is obtained based on the third minimum value m3 and the third upper end value H3.

In addition, it is preferable that "the degree of the gradient" is considered as the degree of the decrease in six layers including the second layer 532 to the seventh layer 537 that are the N-2 layers excluding the first layer 531 and the eighth layer 538 that is the N-th layer. The first layer 531 and the eighth layer 538 are likely to be largely affected by the other layers, and it is not appropriate to consider the degree of the gradient.

In the second layer 532 to the seventh layer 537, it is preferable that the number of layers where the ratio m1/H1 is less than 90% is less than (N-2)/2, and the number of layers where the ratio m2/H2 is less than 90% is (N-2)/2 or more. In the present embodiment, N is 8, and thus (N-2)/2 is 3. When the ratio m1/H1 and the ratio m2/H2 satisfy the above-described relationship, a variation in the first element E1 in the piezoelectric layer 53 can be reduced as compared to the second element E2. Further, it is preferable that the number of layers where the ratio m1/H1 is less than 90% is less than (N-2)/2, and the number of layers where the ratio m3/H3 is less than 90% is (N-2)/2 or more. When the ratio m1/H1 and the ratio m3/H3 satisfy the above-described relationship, a variation in the first element E1 in the piezoelectric layer 53 can be reduced as compared to the third element E3.

The meanings of the ratio m1/H1, the ratio m2/H2, and the ratio m3/H3 will be supplementarily described using the ratio m1/H1 as a representative example. In one layer, the first upper end value H1 is less than the first lower end value U1 with few exceptions. As described above, the reason for this is that the first element E1 decreases from bottom to top. When the decrease in the layer at this time linearly occurs from the first lower end value U1 to the first upper end value H1, or when the decrease has a so-called upwardly convex gradient, for example, starts from the first lower end value U1, temporarily increases halfway, decreases, and reaches the first upper end value H1, the first upper end value H1 is the first minimum value m1 in the layer. That is, m1/H1 = 100%. Conversely, m1/H1 < 100% represents that a portion where the first minimum value m1 is less than the first upper end value H1 is present at any position of the layer. When visually expressed using a curved shape by the SIMS measurement of FIGS. 6 to 9, it can be said that a downwardly convex gradient is present at any position in the layer. As the ratio m1/H1 largely falls below 100%, it can be said that the degree of the downwardly convex gradient of the first element E1 is large in the layer. Further, as the degree of the downwardly convex gradient in the layer increases, the degree of the downwardly convex gradient in the entire piezoelectric layer 53 can be evaluated to be larger. The same applies to the ratio m2/H2 and the ratio m3/H3.

In the first example, in the second layer 532 to the seventh layer 537, the number of layers where the ratio m1/H1 is less than 90% is 0. Therefore, the number of layers where the ratio m1/H1 is less than 90% is less than 3. Further, in the first example, in the second layer 532 to the seventh layer 537, the number of layers where the ratio m2/H2 is less than 90% is 4. Therefore, the number of layers where the ratio m1/H1 is less than 90% is 3 or more. Further, in the first example, in the second layer 532 to the seventh layer 537, the number of layers where the ratio m3/H3 is less than 90% is 3. Therefore, the number of layers where the ratio m1/H1 is less than 90% is 3 or more. Accordingly, in the first example, it can be evaluated that, in the entire piezoelectric layer 53, the degree of the gradient in the first element E1 is small, and the degree of the downwardly convex gradient in the second element E2 and the third element is large.

In the second example, in the second layer 532 to the seventh layer 537, the number of layers where the ratio m1/H1 is less than 90% is 0. Therefore, the number of layers where the ratio m1/H1 is less than 90% is less than 3. Further, in the second example, in the second layer 532 to the seventh layer 537, the number of layers where the ratio m2/H2 is less than 90% is 6. Therefore, the number of layers where the ratio m1/H1 is less than 90% is 3 or more. Further, in the second example, in the second layer 532 to the seventh layer 537, the number of layers where the ratio m3/H3 is less than 90% is 3. Therefore, the number of layers where the ratio m1/H1 is less than 90% is 3 or more. Accordingly, in the second example, it can be evaluated that, in the entire piezoelectric layer 53, the degree of the gradient in the first element E1 is small, and the degree of the downwardly convex gradient in the second element E2 and the third element is large.

In the third example, in the second layer 532 to the seventh layer 537, the number of layers where the ratio m1/H1 is less than 90% is 2. Therefore, the number of layers where the ratio m1/H1 is less than 90% is less than 3. Further, in the third example, in the second layer 532 to the seventh layer 537, the number of layers where the ratio m2/H2 is less than 90% is 6. Therefore, the number of layers where the ratio m1/H1 is less than 90% is 3 or more. Further, in the third example, in the second layer 532 to the seventh layer 537, the number of layers where the ratio m3/H3 is less than 90% is 6. Therefore, the number of layers where the ratio m1/H1 is less than 90% is 3 or more. Accordingly, in the third example, it can be evaluated that, in the entire piezoelectric layer 53, the degree of the downwardly convex gradient in the first element E1 is small, and the degree of the gradient in the second element E2 and the third element is large.

In Comparative Example, in the second layer 532 to the seventh layer 537, the number of layers where the ratio m1/H1 is less than 90% is 5. Therefore, the number of layers where the ratio m1/H1 is not less than 90% is less than 2. In Comparative Example, in the second layer 532 to the seventh layer 537, the number of layers where the ratio m2/H2 is less than 90% is 6. Therefore, the number of layers where the ratio m1/H1 is less than 90% is 3 or more. In addition, in Comparative Example, in the second layer 532 to the seventh layer 537, the number of layers where the ratio m3/H3 is less than 90% is 6. Therefore, the number of layers where the ratio m1/H1 is less than 90% is 3 or more. Accordingly, in Comparative Example, it can be evaluated that, in the entire piezoelectric layer 53, the degree of the downwardly convex gradient in all the first element E1, the second element E2, and the third element is large.

Further, the number of layers where the ratio m1/H1 is less than 90% is preferably 0. When the number of the layers is 0, a variation in the first element E1 in the piezoelectric layer 53 can be sufficiently reduced.

In the first example and the second example, the number of layers where the ratio m1/H1 is less than 90% is 0. In the first example and the second example, a decrease in piezoelectric characteristics can be suppressed as compared to Comparative Example.

In FIGS. 6 to 9, the magnitude of the degree of the downwardly convex gradient is illustrated based on the ratio m1/H1, the ratio m2/H2, and the ratio m3/H3. However, conversely, the magnitude of the degree of the upwardly convex gradient may be considered based on the ratio M1/U1, the ratio M2/U2, and the ratio M3/U3.

It is preferable that the degree of the gradient of the first element E1 is obtained based on the first maximum value M1 and the first lower end value U1. It is preferable that the degree of the gradient of the second element E2 is obtained based on the second maximum value M2 and the second lower end value U2. The degree of the gradient of the first element E1 is clarified by using the first maximum value M1 and the first lower end value U1, and the degree of the gradient of the second element E2 is clarified by using the second minimum value m2 and the second upper end value H2.

Further, the degree of the gradient of the first element E1 is particularly clarified by using the first minimum value m1, the first upper end value H1, the second minimum value m2, and the second upper end value H2, and the degree of the gradient of the second element E2 is particularly clarified by using the second minimum value m2, the second upper end value H2, the second maximum value M2, and the second lower end value U2.

In addition, the same applies to the third element E3 as in the second element E2. It is preferable that the degree of the gradient of the third element E3 is obtained based on the third maximum value M3 and the third lower end value U3.

In the second layer 532 to the seventh layer 537, it is preferable that the number of layers where the ratio M1/U1 is more than 110% is less than (N-2)/2, and the number of layers where the ratio M2/U2 is more than 110% is (N-2)/2 or more. In the present embodiment, N is 8, and thus (N-2)/2 is 3. When the ratio M1/U1 and the ratio M2/U2 satisfy the above-described relationship, a variation in the first element E1 in the piezoelectric layer 53 can be reduced as compared to the second element E2. Further, it is preferable that the number of layers where the ratio M1/U1 is more than 110% is less than (N-2)/2, and the number of layers where the ratio M3/U3 is more than 110% is (N-2)/2 or more. When the ratio M1/U1 and the ratio M3/U3 satisfy the above-described relationship, a variation in the first element E1 in the piezoelectric layer 53 can be reduced as compared to the third element E3.

The meanings of the ratio M1/U1, the ratio M2/U2, and the ratio M3/U3 will be supplementarily described using the ratio M1/U1 as a representative example. As described above, in one layer, the first upper end value H1 is less than the first lower end value U1 with few exceptions. When the decrease in the layer at this time linearly occurs from the first lower end value U1 to the first upper end value H1, or when the decrease has a so-called downwardly convex gradient, for example, starts from the first lower end value U1, temporarily decreases halfway, increases, and reaches the first upper end value H1, the first lower end value U1 is the first maximum value M1 in the layer. That is, M1/U1 = 100%. Conversely, M1/U1 > 100% represents that a portion where the first maximum value M1 is more than the first lower end value U1 is present at any position of the layer. When visually expressed using a curved shape by the SIMS measurement of FIGS. 6 to 9, it can be said that a upwardly convex gradient is present at any position in the layer. As the ratio M1/U1 largely exceeds 100%, it can be said that the degree of the upwardly convex gradient of the first element E1 is large in the layer. Further, as the degree of the upwardly convex gradient in the layer increases, the degree of the upwardly convex gradient in the entire piezoelectric layer 53 can be evaluated to be larger. The same applies to the ratio M2/U2 and the ratio M3/U3.

The exception described above regarding the downwardly convex shape and the upwardly convex shape is a case where the change itself of the decrease from the first upper end value H1 to the first lower end value U1 in the layer collapses. In this case, m1/H1 > 100% or M1/U1 < 100% may be satisfied.

As illustrated in FIGS. 6 to 9, in each of the first example, the second example, the third example, and Comparative Example, the number of layers where each of the ratio M1/U1, the ratio M2/U2, and the ratio M3/U3 is more than 110% is less than (N-2)/2. That is, in all of the first example, the second example, the third example, and Comparative Example, the degree of the upwardly convex gradient is small. However, it is undeniable that, when the downwardly convex gradient or the upwardly convex gradient is large, the degrees of the gradients of the first element E1, the second element E2, and the third element E3 are large. For example, in Comparative Example illustrated in FIG. 9, regarding the first element E1, the degree of the upwardly convex gradient is small, but the degree of the downwardly convex gradient is large. Therefore, a decrease in piezoelectric characteristics occur. However, even when the degree of the downwardly convex gradient is small, but the degree of the upwardly convex gradient is large, a decrease in piezoelectric characteristics also occurs.

As described above, in the present embodiment, the first element E1 is Bi, and the second element E2 is Fe. When the above-described elements are used, for example, an example where the seed layer 54 includes PbBiFeTiO or BiFeTiO is assumed. In addition, for example, when the material of the seed layer 54 is PbBiFeTiO, the amount of Pb that is the A-site element is smaller than that of Bi. Therefore, regarding the substitution of Pb with the A-site element of the piezoelectric layer 53 of KNN, a large problem is not substantially likely to occur. On the other hand, a larger amount of Bi than Pb is present in the seed layer 54. Therefore, the effect of moving Bi the piezoelectric layer 53 is higher than Pb.

In addition, in the present embodiment, the first element E1 may be Bi, and the second element E2 may be Ti. When the above-described elements are used, for example, an example where the seed layer 54 includes PbBiFeTiO or BiFeTiO is assumed.

In addition, as described above, in the piezoelectric layer 53, the Na-rich portion and the K-rich portion are present in the SIMS measurement result. That is, as illustrated in FIGS. 6 to 9, the two regions having different ratios between the K intensity and the Na intensity are present in the piezoelectric layer 53. Specifically, in the piezoelectric layer 53, a first region where the K/Na value is a first value and a second region A2 where the K/Na value is a second value more than the first value are present. The first region corresponds to the Na-rich portion. The second region corresponds to the K-rich portion. In addition, the first region corresponds to each of the plurality of layers in the piezoelectric layer 53, that is, an inner region of one layer. The second region A2 corresponds to a boundary region between two adjacent layers.

As described above, when the piezoelectric layer 53 includes the Na-rich first region A1 and the K-rich second region A2, piezoelectric characteristics may decrease due to introduction of other elements. Accordingly, in the piezoelectric layer 53 including the first region A1 and the second region A2, it is suitable that the degree of the gradient of the first element E1 is smaller than the degree of the gradient of the second element E2 from the viewpoint of suppressing a decrease in piezoelectric characteristics.

In addition, when the piezoelectric layer 53 is measured by SIMS along the lamination direction, in each of the layers in the piezoelectric layer 53, a change in Nb intensity is smaller than a change in K intensity and a change in Na intensity. In the examples and Comparative Example, the Nb intensity is substantially constant. Specifically, the rate of change in the Nb intensity is within a range of ±5%. The Nb intensity that is the B-site element is constant, and the above-described problem of the A-site element is not likely to occur.

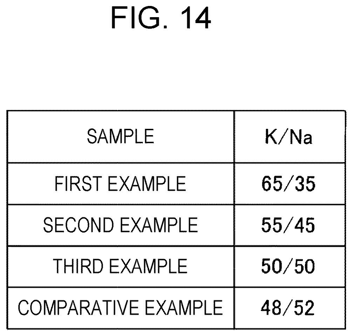

FIG. 14 is a diagram illustrating ratios between K and Na in precursor solutions for forming the piezoelectric layers 53 in the examples and Comparative Example.

As described above, in the present embodiment, each layer in the piezoelectric layer 53 is formed by applying, for example, a precursor solution that is formed of a sol including a metal complex including K, Na, and Nb to the seed layer 54 to form a piezoelectric precursor film, and drying and degreasing the piezoelectric precursor film at a predetermined temperature.

As illustrated in FIG. 10, in each of the examples and Comparative Example, the ratios between K and Na in the precursor solutions are different from each other. The precursor solution includes K and Na at a ratio of x:1-x. It is preferable that x ≥ 50.

As illustrated in FIG. 10, in the first example, K:Na = 65:35. In the second example, K:Na = 55:45. In the third example, K:Na = 50:50. In Comparative Example, K:Na = 48:52. Accordingly, in each of the examples, x ≥ 50 is satisfied. On the other hand, in Comparative Example, x ≥ 50 is not satisfied.

The ratio between K and Na is considered to affect the degree of each of the gradients of the first element E1 and the second element E2. By satisfying x ≥ 50, the degree of the gradient of the first element E1 is likely to be smaller than the degree of the gradient of the second element E2. Accordingly, a decrease in the piezoelectric characteristics of the piezoelectric layer 53 can be suppressed.

Further, it is more preferable that x ≥ 55. In the first example and the second example, x ≥ 55 is satisfied. By satisfying x ≥ 55, the degree of the gradient of the first element E1 is more likely to be smaller than the degree of the gradient of the second element E2.

In addition, in order to obtain the piezoelectric characteristics of the piezoelectric layer 53, it is desirable that K and Na are about the same in the ratio. Therefore, it is preferable that x is not much larger than 50. Specifically, it is preferable that x < 70.

As the method of controlling the degree of each of the gradients of the first element E1 and the second element E2, in addition to the method of changing the ratio between K and Na, for example, a method of adjusting the film thickness of each of the layers in the piezoelectric layer 53 and a method of adjusting the firing temperature during manufacturing can be considered.

### 2. Modified Examples

The embodiments described above may be modified in various ways. A specific modification aspect that can be applied to the embodiments described above will be described below. Two or more aspects optionally selected from the following examples can be combined as appropriate within a range in which the aspects are not mutually contradictory.

The "liquid ejecting head" may be a circulation type head having a so-called circulation flow path.

The "image forming device" may be adopted in various devices such as facsimile devices and copy machines, in addition to devices dedicated to printing. The use of the image forming device is not limited to printing. For example, image forming devices that eject a coloring material solution are used as manufacturing devices that form a color filter for display devices such as liquid crystal display panels. In addition, image forming devices that eject a solution of a conductive material are used as manufacturing devices that form wiring and electrodes of a wiring substrate. In addition, image forming devices that eject a solution of an organic substance related to a living body are used, for example, as manufacturing devices for manufacturing biochips.

The piezoelectric element according to the present disclosure is not limited to the liquid ejecting head or the liquid ejecting apparatus, and may be a device having a function of converting a voltage and a mechanical force to each other, for example, applying a voltage to generate a mechanical force or applying a mechanical force to generate a voltage. The piezoelectric element according to the present disclosure may be, for example, an ultrasonic motor, a vibration type dust removing device, a piezoelectric transformer, a piezoelectric speaker, a piezoelectric pump, an ultrasonic wave detector, an angular velocity sensor, an acceleration sensor, a vibration sensor, an inclination sensor, a pressure sensor, a collision sensor, a human sensor, an infrared sensor, a terahertz sensor, a heat detection sensor, a pyroelectric sensor, a piezoelectric sensor, a ferroelectric memory (FeRAM), a ferroelectric transistor (FeFET), a ferroelectric logic (FeLogic), a ferroelectric capacitor, a wavelength converter, an optical waveguide, an optical path modulator, a refractive index control element, or an electronic shutter mechanism.

The present disclosure is described above based on the preferred embodiments, but the present disclosure is not limited to the above embodiments. In addition, the configuration of each portion of the present disclosure can be replaced with any configuration having the same function in the above-described embodiments, and any configuration can be added.

## Claims

1. A piezoelectric element comprising:
a lower electrode;
a piezoelectric layer having a perovskite structure that includes K and Na in an A-site and includes Nb in a B-site;
an upper electrode; and
a seed layer having a perovskite structure that includes a first element in an A-site and includes a second element in a B-site and configured to control an orientation of the piezoelectric layer, wherein
the lower electrode, the seed layer, the piezoelectric layer, and the upper electrode are arranged in this order along a lamination direction,
in the piezoelectric layer, the first element and the second element decrease with gradients from bottom to top along the lamination direction, and
a degree of the gradient of the first element in the piezoelectric layer is smaller than a degree of the gradient of the second element in the piezoelectric layer.

2. The piezoelectric element according to claim 1, wherein
in the piezoelectric layer, N layers including a first layer to an N-th layer are laminated from bottom to top,
the degree of the gradient of the first element is obtained based on a first minimum value that is a minimum value among intensities of the first element in the respective layers and a first upper end value that is an intensity of the first element in an uppermost region of the respective layers when the piezoelectric layer is measured by SIMS along the lamination direction, and
the degree of the gradient of the second element is obtained based on a second minimum value that is a minimum value among intensities of the second element in the respective layers and a second upper end value that is an intensity of the second element in the uppermost region of the respective layers when the piezoelectric layer is measured by SIMS along the lamination direction.

3. The piezoelectric element according to claim 2, wherein
in N-2 layers excluding the first layer and the N-th layer, the number of layers where a ratio of the first minimum value to the first upper end value is less than 90% is less than (N-2)/2, and
in the N-2 layers excluding the first layer and the N-th layer, the number of layers where a ratio of the second minimum value to the second upper end value is less than 90% is (N-2)/2 or more.

4. The piezoelectric element according to claim 3, wherein
in the N-2 layers excluding the first layer and the N-th layer, the number of the layers where the ratio of the first minimum value to the first upper end value is less than 90% is 0.

5. The piezoelectric element according to claim 1, wherein
in the piezoelectric layer, N layers including a first layer to an N-th layer are laminated from bottom to top,
the degree of the gradient of the first element is obtained based on a first maximum value that is a maximum value among intensities of the first element in the respective layers and a first lower end value that is an intensity of the first element in a lowermost region of the respective layers when the piezoelectric layer is measured by SIMS along the lamination direction, and
the degree of the gradient of the second element is obtained based on a second maximum value that is a maximum value among intensities of the second element in the respective layers and a second lower end value that is an intensity of the second element in the lowermost region of the respective layers when the piezoelectric layer is measured by SIMS along the lamination direction.

6. The piezoelectric element according to claim 1, wherein
the seed layer further includes a third element in a B-site,
in the piezoelectric layer, the third element decreases with a gradient from bottom to top along the lamination direction, and
the degree of the gradient of the first element is smaller than a degree of the gradient of the third element.

7. The piezoelectric element according to claim 1, wherein
in the piezoelectric layer, N layers including a first layer to an N-th layer are laminated from bottom to top, and
when the piezoelectric layer is measured by SIMS along the lamination direction, in each of the layers, a first region where a K/Na value that is a ratio of a K intensity to an Na intensity is a first value and a second region where the K/Na value is a second value more than the first value are present.

8. The piezoelectric element according to claim 7, wherein
the first region corresponds to an inner region of one layer, and the second region corresponds to a boundary region between two layers.

9. The piezoelectric element according to claim 1, wherein
in the piezoelectric layer, N layers including a first layer to an N-th layer are laminated from bottom to top, and
when the piezoelectric layer is measured by SIMS along the lamination direction, in each of the layers, a change in Nb intensity is smaller than a change in K intensity and a change in Na intensity.

10. The piezoelectric element according to claim 1, wherein
the first element is Bi, and the second element is Fe.

11. The piezoelectric element according to claim 1, wherein
the first element is Bi, and the second element is Ti.

12. The piezoelectric element according to claim 1, wherein
the piezoelectric layer is formed of a precursor solution including K and Na at a ratio of x:1-x, and
x ≥ 50 is satisfied.

13. The piezoelectric element according to claim 12, wherein
x ≥ 55 is satisfied.

14. The piezoelectric element according to claim 12, wherein
x < 70 is satisfied.

15. A liquid ejecting head comprising:
the piezoelectric element according to claim 1;
a pressure chamber in which liquid is circulated to apply a pressure to the liquid by the piezoelectric element; and
a nozzle configured to eject the liquid using the pressure applied in the pressure chamber.
